# EUROPEAN PATENT SPECIFICATION

(11) **EP 2 747 289 B1**
(45) Date of publication and mention of the grant of the patent: **15.07.2015**
(21) Application number: 12198989.1
(22) Date of filing: 21.12.2012
(51) Int. Cl.: H03K 21/40, H04L 7/00

(54) **Synchronizer circuit and method for synchronizing components using different clock signals**
Synchronisationsschaltung und Verfahren zum Synchronisieren von Bauteilen unter Verwendung unterschiedlicher Taktsignale
Procédé et circuit de synchronisation permettant de synchroniser des composants à l'aide de différents signaux d'horloge

(43) Date of publication of application: 25.06.2014
(73) Proprietor: Huawei Technologies Co., Ltd., Longgang District Shenzhen, Guangdong 518129 (CN)
(72) Inventor: Reches, Shlomo, 80992 Munich (DE); Zecharia, Rami, 80992 Munich (DE); Umansky, Alex, 80992 Munich (DE); Elad, Yuval, 80992 Munich (DE)
(74) Representative: Kreuz, Georg Maria

(56) References cited:
- US-A- 5 390 190
- US-A1- 2010 322 365
- US-B1- 6 598 191

## Description

### Technical Field

The present invention pertains to a synchronizer circuit and a method for synchronizing components using different clock signals, in particular for use in a data processing system having differently clocked system components.

### Background

Digital design of electronic circuitry being clocked with different clock signals in different clock domains is very common both on chip level and on board level. A system having a central processing unit, at least one memory component and input/output interfaces may use a different clock for each unit. One reason for choosing different clocks is the decoupling of clock dependencies between the units so that each unit may be provided with an own clock signal optimized with regard to its requirements.

For example, in order to drive a data processing system with maximum performance, the maximum central processing unit (CPU) frequency should be chosen. Memory components may have a maximum admissible frequency that is lower than the maximum CPU frequency. By decoupling the clocks the optimum CPU frequency may be selected irrespective of what frequency is chosen for the memory component.

On the other hand, in order to drive a data processing system with the lowest power consumption, each unit should be clocked according to its own minimum frequency irrespective of what minimum frequency the remaining components might have.

If multiple clock domains are employed as e.g. described in document US 6,598,191 B1 and the units are to communicate among each other, provisions have to be made to ensure an error free communication. Mostly, a synchronizer circuit is employed comprising a FIFO buffer or two latching registers in order to transfer data items from one clock rate to the other clock rate.

In order to avoid sampling metastable data signals, a synchronizing signal is usually generated to define valid sampling points at which metastability can be excluded with a very high probability. For example, sampling a 2-bit bus asynchronously, i.e. without synchronizer, may introduce read-out errors when the two bits of the bus are to be changed but due to clock skew one of the bits gets read out earlier than the other. The outcome of such a read-out process will be unpredictable and may lead to problems in the further chain of processing performed with a different clock ratio. A solution to this problem conventionally consists in using a single wired or "grey coded" bus which allows only for a single signal to be changed between sampling points. Feedback from the components operated using the different clock signal may be collected and fed into state machines configured to generate the synchronizing signal to ensure the validity of data items and the error free transfer of data.

Document US 8,078,772 B2 discloses a synchronizing device adapted to read in data from a first clock domain unit into a second clock domain unit. A control module controls the sampling point of the synchronizing device according to a sample history of phase relationships between the two clock signals of the two clock domains.

Document US 5,004,933 A discloses a phase-selectable flip-flop which upon command latches data either on the rising or the falling edge of a clock pulse by using a switchable transparent latch in series with a D-flip-flop.

Document US 2010/0322365 A1 discloses a synchronizing apparatus for synchronizing two different clock domains having a rising edge intermediate flip-flop or a falling edge intermediate flip-flop.

However, there is a need for error-free synchronization between different clock domains that takes into account setup-and-hold timing requirements between data transferring flip-flops of both domains and that especially provides data transfer with low latency.

### Summary

Accordingly, an idea of the present invention is to use both the negative and positive edges of a second clock signal for data transfer. One of the edge types may be preferentially be used for determining a sampling point of a data item. For each of the sampling points it will be determined whether the time interval between a first sampling point of a data item in a first flip-flop and the read-out sampling point in a second flip-flop is the longest among the other possible sampling points to ensure relaxed timing and easier to meet the necessary setup and hold times of the associated flip-flops.

By selecting either the respective edge of a first edge type or, alternatively, the following edge of a second edge type, the latency of the data transfer maybe kept as minimal as possible while at the same time guaranteeing with sufficient probability that metastable states may not occur in the reading flip-flop.

One advantage of such procedure is that a synchronizing signal between the flip-flops operated using different clock signals is not necessary.

Consequently, a first aspect of the present invention relates to a synchronizer circuit, comprising a first flip-flop operated with a first clock signal, the first flip-flop being configured to read a data item at a first sampling point correlating with a first edge of a first edge type of the first clock signal, a second flip-flop operated with a second clock signal, the second flip-flop being configured to read the data item from the first flip-flop at a read-out sampling point, and a finite state machine coupled to the second flip-flop, the finite state machine being configured to select a second sampling point as the read-out sampling point of the second flip-flop, wherein the second sampling point correlates with a second edge of the first edge type of a second clock rate, which second edge directly follows the first edge, if the time interval between the occurrence of the first edge and the second edge is greater than a predeterminable threshold, and the finite state machine being configured to select a third sampling point as the read-out sampling point of the second flip-flop, wherein the third sampling point correlates with a third edge of a second edge type of the second clock rate, which third edge directly follows the second edge, if the time interval between the occurrence of the first edge and the second edge is smaller than or equal to a predeterminable threshold.

According to a first possible implementation form of the first aspect as such, the ratio between the first clock rate and the second clock rate may correspond to a fraction A / B, wherein A and B are natural numbers. Advantageously, for an integer fractional ratio between the clock rates the temporal relationship of the two clock rates between each other repeats in cycles. Therefore, only a finite number of different sampling points exists during which the data item may be read out by the second flip-flop. This finite number may be predetermined in advance and stored in a finite state machine for controlling the second flip-flop. Thus, the computational burden on the synchronizer circuit 200 is reduced even further. The sampling edge selection can be done by design and not during run-time.

According to a second possible implementation form of the synchronizer circuit according to the first aspect as such or according to the first possible implementation form of the first aspect, the first edge type may be a positive edge, the second edge type may be a negative edge, vice versa.

According to a third possible implementation form of the first aspect as such or according to the any of the preceding implementation forms of the first aspect, the predeterminable threshold may depend on the setup and hold times of the first and/or second flip-flop.

According to a fourth possible implementation form of the first aspect as such or according to the any of the preceding implementation forms of the first aspect, the first flip-flop may be a D-flip-flop.

According to another possible implementation form of the first aspect as such or according to the any of the preceding implementation forms of the first aspect, the second flip-flop may be a D-flip-flop.

According to a fifth possible implementation form of the first aspect as such or according to the any of the preceding implementation forms of the first aspect, the synchronizer circuit may further comprise a third flip-flop operated with a second clock signal coupled to the second flip-flop, the third flip-flop being configured to read the data item from the second flip-flop at the second clock rate.

Advantageously, the provision of an additional buffering flip-flop may compensate for the occasional sampling of the data items only half a clock cycle before the data item is being processed with the second clock signal. If such timing requirements are too tight the third flip-flop may provide additional delay at the expense of longer latency.

According to a sixth possible implementation form of the first aspect as such or according to the any of the preceding implementation forms of the first aspect, the synchronizer circuit may further comprise a start-up circuit, the start-up circuit may comprise a fourth flip-flop clocked with the second clock rate coupled to the finite state machine, a fifth flip-flop clocked with the second clock rate coupled to the fourth flip-flop and a sixth flip-flop clocked with the first clock rate. The finite state machine may be configured to input a starting signal to the fourth flip-flop and to receive a pattern signal from the fifth flip-flop. The sixth flip-flop may be configured to output a reset signal to the fifth flip-flop resetting the pattern signal to zero, if an edge of the first edge type of the second clock rate occurs during processing of the starting signal in the fourth and fifth flip-flop with the first clock rate.

Such a start-up circuit has the advantage that after powering up a PLL generating the different clock rates the finite state machine may be put in synchronicity with the actual timing differences of the clock rates. The finite state machine may discover the sampling points where the different clock signals have their edges aligned.

According to a seventh possible implementation form of the sixth preceding implementation form of the first aspect, the synchronizer circuit may comprise a counter coupled to the finite state machine, the counter being configured to control the sequence of the second and third sampling points depending on a bit sequence of the pattern signal.

The counter may advantageously provide for a running sequence generator in case of clock rates with an integer fractional ratio.

According to a eighth possible implementation form of the first aspect as such or according to the any of the preceding implementation forms of the first aspect, the first clock rate and the second clock rate may be generated by the same phased lock loop or the same phase locked loop tree to generate mutually dependent clock rates having predetermined temporal relationships between the respective edges.

According to a second aspect of the invention, a method for synchronizing components using different clock signals is provided, the method comprising the steps of reading a data item into a first flip-flop, which is operated using a first clock signal, at a first sampling point correlating with a first edge of a first edge type of the first clock rate, reading the data item from the first flip-flop into a second flip-flop, which is operated using a first clock signal, at a second sampling point correlating with a second edge of the first edge type of the second clock signal, which second edge directly follows the first edge, if the time interval between the occurrence of the first edge and the second edge is greater than a predeterminable threshold, and reading the data item from the first flip-flop into the second flip-flop operated with a second clock signal at a third sampling point correlating with a third edge of a second edge type of the second clock rate, which third edge directly follows the second edge, if the time interval between the occurrence of the first edge and the second edge is smaller than or equal to a predeterminable threshold.

According to a first possible implementation form of the second aspect as such, the ratio between the first clock rate and the second clock rate may correspond to a fraction A / B, wherein A and B are natural numbers.

Advantageously, for an integer fractional ratio between the clock rates the temporal relationship of the two clock rates between each other repeats in cycles. Therefore, only a finite number of different sampling points exist during which the data item may be read out by the second flip-flop. This finite number may be predetermined in advance and stored in a finite state machine for controlling the second flip-flop. Thus, the computational burden on the synchronizer circuit is reduced even further.

According to a second possible implementation form of the second aspect as such or according to the first implementation form of the second aspect, the first edge type may be a positive edge.

According to another possible implementation form of the second aspect as such or according to the any of the preceding implementation forms of the second aspect, the second edge type may be a negative edge.

According to a third possible implementation form of the second aspect as such or according to the any of the preceding implementation forms of the second aspect, the predeterminable threshold depends on the setup and hold times of the first and/or second flip-flop.

According to a fourth possible implementation form of the second aspect as such or according to the any of the preceding implementation forms of the second aspect, the first flip-flop may be a D-flip-flop.

According to another possible implementation form of the second aspect as such or according to the any of the preceding implementation forms of the second aspect, the second flip-flop may be a D-flip-flop.

According to a fifth possible implementation form of the second aspect as such or according to the any of the preceding implementation forms of the second aspect, data items may be read into the first flip-flop at a sequence of the first sampling points of the first clock rate. According to another possible implementation form of the second aspect as such or according to the any of the preceding implementation forms of the second aspect, the sequence of the second and third sampling points corresponding to the respective sequence of the first sampling points may be preconfigured in advance.

### Brief Description of the Drawings

The accompanying drawings are included to provide a further understanding of the disclosure. They illustrate embodiments and may help to explain the principles of the invention in conjunction with the description. Other embodiments and many of the intended advantages, envisaged principles and functionalities will be appreciated as they become better understood by reference to the detailed description as following hereinbelow. The elements of the drawings are not necessarily drawn to scale relative to each other. In general, like reference numerals designate corresponding similar parts.
- Fig. 1: schematically illustrates a clock signal and timing diagram for a synchronizer circuit according to an embodiment of the present invention.
- Fig. 2: schematically illustrates a synchronizer circuit according to another embodiment of the present invention.
- Fig. 3: schematically illustrates a start-up circuit for a synchronizer circuit according to a further embodiment of the present invention.
- Fig. 4: schematically illustrates a method for synchronizing components using different clock signals according to a further embodiment of the present invention.

### Detailed Description

In the following detailed description, reference is made to the accompanying drawings, and in which, by way of illustration, specific embodiments are shown. It should be obvious that other embodiments may be utilized and structural or logical changes may be made without departing from the scope of the present invention. Unless specifically noted otherwise, functions, principles and details of each embodiment may be combined with other embodiments. Generally, this application is intended to cover any adaptations or variations of the specific embodiments discussed herein. Hence, the following detailed description is not to be taken in a limiting sense, and the scope of the present invention is defined by the appended claims.

In the following, reference is also made to methods and method steps, which are schematically and exemplarily illustrated in flow charts and block diagrams. It should be understood that the methods described in conjunction with those illustrative drawings may easily be performed by embodiments of systems, apparatuses and/or devices as well. In particular, it should be obvious that the systems, apparatuses and/or devices capable of performing the detailed block diagrams and/or flow charts are not necessarily limited to the systems, apparatuses and/or devices shown and detailed herein below, but may rather be different systems, apparatuses and/or devices. The terms "first", "second", "third", etc. are used merely as labels, and are not intended to impose numerical requirements on their objects or to establish a certain ranking of importance of their objects.

A clock rate domain in the sense of the present invention may be any component, any group of components or any arrangement of components which is operated with a common clock signal. Clock rate domains may for example be implemented for a data processing system, wherein several or all of its components and groups of components may be associated with different clock rate domains, such as a flip-flop, a central processing unit, a memory device components, interface components and the like.

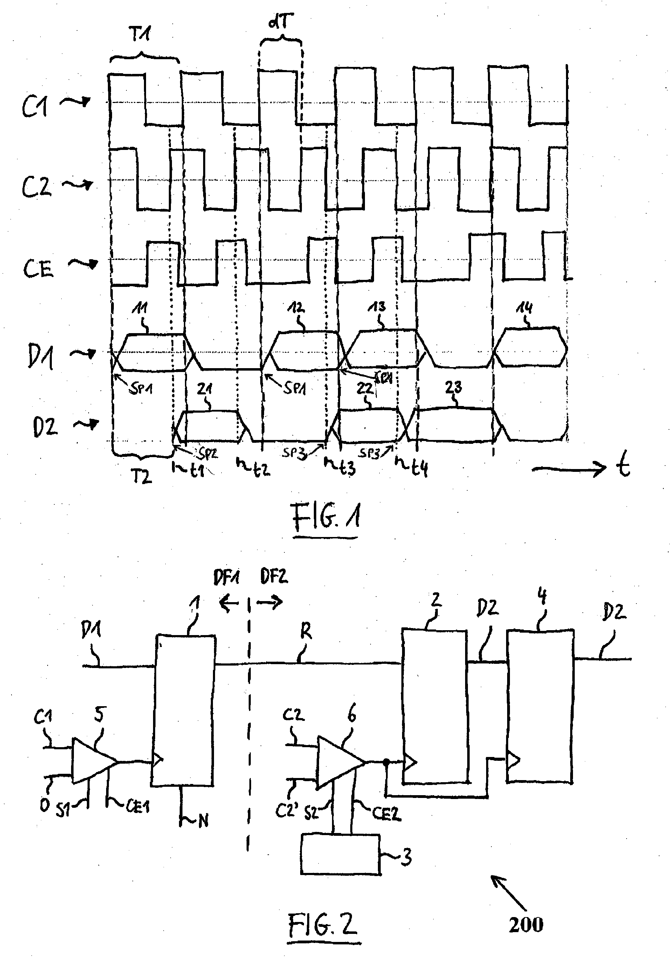

Fig. 1 shows a schematical illustration of a clock signal and timing diagram for a synchronizer circuit 200. A first clock rate domain may be operated using a first clock signal C1 having a first clock rate 1/T1, T1 is the period of the first clock signal, whereas a second clock rate domain may be operated using a second clock signal C2 having a second clock rate 1/T2, T2 is the period of the second clock signal. The first clock signal C1 and the second clock signal C2 may preferably be generated using the same phase-locked loop (PLL) circuitry or the same PLL tree to guarantee the timing between the edges of the clock signals C1 and C2. In that case, the temporal relationship between the two clock signals is known in advance and stable sampling points may be designed.

Components in the first clock rate domain may be operated using the first clock signal C1. Components in the second clock rate domain may be operated using the second clock signal C2.

In the example of Fig. 1 the clock rates 1/T1 and 1/T2 have a ratio which may be expressed as a fraction of natural or integer numbers. For example, the ratio between the clock rates 1/T1 and 1/T2 may be 5/6, that is, for every five clock cycles of the clock signal C1 six clock cycles of the clock signal C2 happen before the clock cycles of the two clock signals are aligned again. In other words, every five clock cycles of the first clock signal C1 and every six clock cycles of the second clock signal C2, the positive edges of the clock signals will be temporally aligned. Of course, different clock ratios may be used as well, for example 3/4, 5/7, 6/8, 2/3, 1/2, 4/5 or any other ratio of integer or natural numbers. Moreover, the ratio of the clock signals may be such that the first clock rate is larger than the second clock rate.

A signal edge type of a clock signal is a transition either from low to high (0 to 1) or from high to low (1 to 0), the signal edge type may comprise a positive edge and a negative edge, which are also known as the rising edge and falling edge, respectively.

Aligned with edges of the first clock signal C1, data items 11, 12, 13 and 14 of a data input signal D1 may be read in the first clock rate domain. The first sampling points SP1 of the data input signal D1 may align with edges of a first edge type of the first clock signal C1. For example, the first edge type may be positive edges of the first clock signal C1, as exemplarily illustrated in Fig. 1. Of course, negative edges may be used for the first edge type as well.

Data items in the sense of the present invention may refer to information carrying items of a particular data object concerning a specific property of the data at a certain point in time. For example, data items may comprise bits, bit sequences, bytes or any other logically computable quantities of information carrying items.

After a first data item 11 has been read on an edge of a first edge type of the first clock signal C1, the second clock signal C2 is checked for the occurrence of the next edge of the first edge type. In the case of the data item 11, this edge happens at a time t1 which is temporally spaced apart to the first sampling point SP1 by a time interval T2. This time interval T2 is checked, whether it is greater than a first predeterminable threshold. If the time interval T2 (or more generally dT) between the occurrence of the edge of the first sampling point SP1 and the next edge of the first edge type of the second clock signal C2 is greater than the predeterminable threshold, that next edge is selected as the read-out sampling point of the data item 11. The data item 11 is then read out in the second clock rate domain at a second sampling point SP2 as the selected read-out sampling point as a read-out item 21. The sampling point selection may be done by design, thus it is not necessary to select the sampling points during run-time.

If, however, the time interval dT between the occurrence of the edge of the first sampling point and the next edge of the first edge type of the second clock signal C2 is smaller than or equal to the predeterminable threshold, a next edge of the second edge type of the second clock signal C2 is selected as a third sampling point SP3, which edge directly follows the edge of the first edge type under determination. The predeterminable threshold may for example depend on the setup and hold times of the flip-flops used for inputting and reading out the data signal D1. For example, the predeterminable threshold may be chosen to be at least as long as the setup and hold times of the flip-flops used for inputting and reading out the data signal D1. It may also be possible to set the predeterminable threshold to be by a certain security margin higher than the setup and hold times of the flip-flops used for inputting and reading out the data signal D1. By selecting the appropriate edge of a first or second edge type it can be made sure that the time for setting up and holding a stable sample of a data item is always sufficient.

The series of the second and third sampling points SP2 and SP3, i.e. their occurrence or sequence in the course of time, may be determined in advance, especially when the ratio of the two clock rates of the clock signals C1 and C2 is a fraction of natural members, since in that case the clock cycles repeat after a finite number of iterations. This series of sampling points for the read-out may be coded in a clock enable signal CE which enables the respective sampling points when a stable sampling status has been reached in each case. In the example of Fig. 1, the series of sampling points for the read-out include times t1, t2, t3 and t4, wherein t1 and t2 correspond to positive edges of the second clock signal C2 and t3 and t4 correspond to negative edges of the second clock signal C2.

By determining a series of sampling points in the afore-mentioned way, the read-out data signal D2 may be retrieved in the second clock rate domain with the least latency guaranteeing stable sampling points. The timing closure and verification may be performed automatically so that there is no need for timing ignore attributes on the respective timing paths of a synchronizer circuit 200.

Fig. 2 schematically illustrates a synchronizer circuit 200. The synchronizer circuit 200 may be configured to synchronize different clock rate domains. For example, the synchronizer circuit 200 of Fig. 2 may be configured to work according to the clock rates and signal timings as set out in the respective diagram of Fig. 1.

The synchronizer circuit 200 comprises a first flip-flop 1, for example a D-flip-flop, which is operated in the first clock rate domain DF1. To that end, data items of a data signal D1 are input to the first flip-flop 1 under the control of an output signal of a first clock buffer 5. The first clock buffer 5 is fed with the first clock signal C1, a first clock enable signal CE1 and a first clock selection signal S1. The first clock enable signal CE1 may be constantly held at high level in order to activate every clock edge of a first edge type of the first clock signal C1 for triggering the reading of a data item of the data input signal D1 in the first flip-flop 1. The first clock selection signal S1 may be permanently set to a high level in order to always activate the first clock signal C1 as the active clock signal.

If the clock rate of the first clock signal C1 is higher than the clock rate of the second clock signal C2, that is, of the second clock rate domain DF2, the first flip-flop 1 may be provided with a read enable signal N which restricts the rate at which data items are read in according to the lower rate of the second clock signal C2.

The synchronizer circuit 200 comprises a second flip-flop 2, for example a D-flip-flop, which is operated in the second clock rate domain DF2. To that end, data items of the first flip-flop 1 are read in a read-out signal R to the second flip-flop 2 under the control of an output signal of a second clock buffer 6. The second clock buffer 6 is fed with the second clock signal C2, an inverted second clock signal C2', a second clock enable signal CE2 and a second clock selection signal S2. The second clock enable signal CE2 and the second clock selection signal S2 may be output by a finite state machine 3 configured to store a predetermined series of the second and third sampling points for the second flip-flop 2. In particular, the predetermined series may be used to generate the second clock enable signal CE2 to determine the edges of the second clock signal C2 to be activated. Similarly, the predetermined series may be used to generate the second clock selection signal S2 in order to choose the edge type used as sampling point for the second clock signal C2. The output of the second clock buffer 6 may then be used for triggering the reading out a data item in the read-out signal R to generate data items of a data output signal D2.

Occasionally, the logic after the second flip-flop 2 will only have half the cycle time of the second clock signal C2 for setup. If this setup time is sufficient, the latency of the synchronizer circuit 200 is minimal. However, if the setup time is not sufficient, optionally a third flip-flop 4 may be provided clocked with the output of the second clock buffer 6 and generating a delay time interval for the logic components after the synchronizer circuit 200 in order to meet the setup conditions.

By choosing a similar topology for the clock buffers 5 and 6, the clock skew introduced by the control logic for the flip-flops 1 and 2 is minimal. The clock buffers 5 and 6 provide a multiplexer functionality for choosing between positive and negative edges of a clock signal input. For example, the clock buffers 5 and 6 may be implemented using an FPGA library BUFCTRL which may be readily available by ASIC and FPGA vendors.

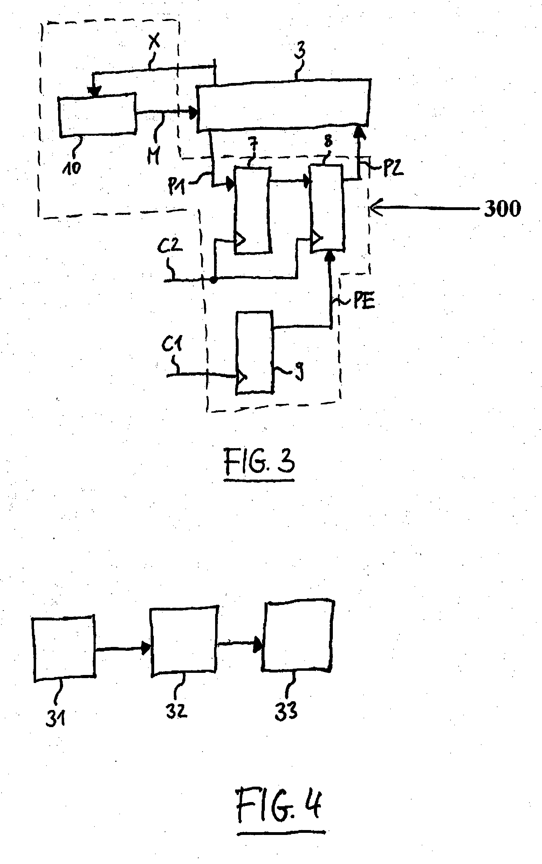

Fig. 3 schematically illustrates a start-up circuit 300 for a synchronizer circuit. The start-up circuit 300 of Fig. 3 may for example be employed in a synchronizer circuit 200 as exemplarily illustrated in Fig. 2 by sharing the finite state machine 3. In particular, the start-up circuit 300 of Fig. 3 may be configured to set up initial conditions for the finite state machine 3 of a synchronizer circuit 200. When powering up, the PLL generating the clock signals will eventually become locked. Thereafter, the logic reset may be released. At this point, the actual state of the first clock rate with respect to the second clock rate is not known. In order to find an initial starting point for the sampling point cycle, the finite state machine 3 may run a start-up procedure utilizing the start-up circuit 300 as exemplarily shown in Fig. 3.

The start-up circuit 300 always works on the clock signal with the higher frequency-exemplary assumed to be the second clock signal C2 in Fig. 3. After each positive edge of the second clock signal C2, it is checked whether a positive edge of the first clock signal C1 fall inside the next clock cycle of the second clock signal C2. This is repeatedly done for all the clock cycles, thus generating a sequence of cycles with following positive edge of the first clock signal C1 and cycles without following positive edge of the first clock signal C1. The cycle before the alignment of both positive edges of the first and second clock signals C1 and C2 will always be a cycle without following positive edge of the first clock signal C1 whereas the cycle after the alignment of both positive edges of the clock signals C1 and C2 will always be a cycle with following positive edge of the first clock signal C1. Thus, by determining the cycle sequence, i.e. the occurrence of the cycles in the course of time, a starting point for the sequence of the second and third sampling points may be found.

Therefore, the start-up circuit 300 may comprise a fourth flip-flop 7 clocked with the second clock signal C2 coupled to the finite state machine 3, a fifth flip-flop 8 clocked with the second clock signal C2 coupled to the fourth flip-flop 7, and a sixth flip-flop 9 clocked with the first clock signal C1. The finite state machine 3 may be configured to input a starting signal P1 to the fourth flip-flop 7 and to receive a pattern signal P2 from the fifth flip-flop 8. The pattern signal P2 is indicative of the sequence of cycles and the respective occurrence of a positive edge of the second clock signal C2 during the current cycle. This is done by the sixth flip-flop 9 which is configured to output a reset signal PE to the fifth flip-flop 8 resetting the pattern signal P2 to zero, if a positive edge of the second clock signal C2 occurs during processing of the starting signal P1 in the fourth and fifth flip-flop 7 and 8 with the rate of the first clock signal C1.

The start-up circuit 300 may also comprise a counter 10 coupled to the finite state machine 3, the counter 10 being configured to control the sequence M of the second and third sampling points SP2 and SP3, i.e. their occurrence or sequence in the course of time, depending on a bit sequence of the pattern signal P2. The bit sequence of the pattern signal P2 may for example code the sequence of the second and third sampling points SP2 and SP3, wherein the respective two states of the bits of the pattern signal P2 code the usage of either a second or a third sampling point, respectively. The counter 10 may for example be a modulo counter which may be reset by the finite state machine 3 according to a counter reset signal X.

Fig. 4 schematically illustrates a method 30 for synchronizing different clock rate domains according to a further embodiment of the present invention. The method 30 may for example be implemented using the synchronizer circuit 200 as explained in conjunction with Figs. 2 and 3. Moreover, the method 30 may take advantage of the findings as explained in conjunction with Fig. 1.

In a first step 31, a data item is read into a first flip-flop in the first clock rate domain at a first sampling point correlating with a first edge of a first edge type of a first clock signal. In a second step 32, the data item is read from the first flip-flop into a second flip-flop in the second clock rate domain at a second sampling point correlating with a second edge of the first edge type of a second clock signal, which second edge directly follows the first edge, if the time interval between the occurrence of the first edge and the second edge is greater than a predeterminable threshold. In a third step 33, the data item is read from the first flip-flop into the second flip-flop in the second clock rate domain at a third sampling point correlating with a third edge of a second edge type of the second clock signal, which third edge directly follows the second edge, if the time interval between the occurrence of the first edge and the second edge is smaller than or equal to a predeterminable threshold.

In the method 30, the ratio between the first clock rate and the second clock rate may correspond to a fraction A / B, wherein A and B are natural or integer numbers. Moreover, the first edge type may be a positive edge and the second edge type may be a negative edge. The predeterminable threshold may depend inter alia on the setup and hold times of the first and/or second flip-flop. Additionally, intermediate logic between the first and second flip-flop may be taken into account as well. The first and second flip-flop of the method 30 may be D-flip-flops.

The method 30 may be performed repeatedly, such that data items are read into the first flip-flop at a sequence of the first sampling points of the first clock signal. Then, the sequence of the second and third sampling points corresponding to the respective sequence of the first sampling points may be preconfigured in advance.

## Claims

1. Synchronizer circuit (200), comprising:
a first flip-flop (1) operated with a first clock signal (C1), the first flip-flop (1) being configured to read a data item (11; 12; 13; 14) at a first sampling point (SP1) correlating with a first edge of a first edge type of the first clock signal (C1);
a second flip-flop (2) operated using a second clock signal (C2), the second flip-flop (2) being configured to read the data item (11; 12; 13; 14) from the first flip-flop (1) at a read-out sampling point; and
a finite state machine (3) coupled to the second flip-flop (2),
the finite state machine (3) being configured to select a second sampling point (SP2) as the read-out sampling point of the second flip-flop (2), wherein the second sampling point (SP2) correlates with a second edge of the first edge type of a second clock signal (C2), wherein the second edge directly follows the first edge, if the time interval (dT) between the occurrence of the first edge and the second edge is greater than a predeterminable threshold, and
the finite state machine (3) being configured to select a third sampling point (SP3) as the read-out sampling point of the second flip-flop (2), wherein the third sampling point (SP3) correlates with a third edge of a second edge type of the second clock signal (C2), wherein the third edge directly follows the second edge, if the time interval (dT) between the occurrence of the first edge and the second edge is smaller than or equal to a predeterminable threshold.

2. Synchronizer circuit (200) according to claim 1, wherein a ratio between the rate of the first clock signal (C1) and the rate of the second clock signal (C2) corresponds to a fraction A / B, wherein A and B are natural numbers.

3. Synchronizer circuit (200) according to one of the claims 1 and 2, wherein the first edge type is a positive edge and the second edge type is a negative edge.

4. Synchronizer circuit (200) according to one of the claims 1 to 3, wherein the predeterminable threshold depends on the setup and hold times of the first and/or second flip-flop (1; 2).

5. Synchronizer circuit (200) according to one of claims 1 to 4, wherein the first and second flip-flop (1; 2) are D-flip-flops.

6. Synchronizer circuit (200) according to one of the claims 1 to 5, further comprising:
a third flip-flop (4) which is operated using the second clock signal (C2) coupled to the second flip-flop (2), the third flip-flop (4) being configured to read the data item (21; 22; 23) from the second flip-flop (2) at the second clock signal (C2).

7. Synchronizer circuit (200) according to one of the claims 1 to 6, further comprising a start-up circuit (300), the start-up circuit (300) comprising:
a fourth flip-flop (7) clocked with the second clock signal (C2) coupled to the finite state machine (3);
a fifth flip-flop (8) clocked with the second clock signal (C2) coupled to the fourth flip-flop (7); and
a sixth flip-flop (9) clocked with the first clock signal (C1),
wherein the finite state machine (3) is configured to input a starting signal (P1) to the fourth flip-flop (7) and to receive a pattern signal (P2) from the fifth flip-flop (8), and
wherein the sixth flip-flop (9) is configured to output a reset signal (PE) to the fifth flip-flop (8) resetting the pattern signal (P2) to zero, if an edge of the first edge type of the second clock signal (C2) occurs during processing of the starting signal (P1) in the fourth and fifth flip-flop (7; 8) with the first clock signal (C1).

8. Synchronizer circuit (200) according to claim 7, further comprising:
a counter (10) coupled to the finite state machine (3), the counter (10) being configured to control the sequence (M) of the second and third sampling points (SP2; SP3) depending on a bit sequence of the pattern signal (P2).

9. Synchronizer circuit (200) according to one of the claims 1 to 8, wherein the first clock signal (C1) and the second clock signal (C2) are generated by the same phased lock loop or the same phase locked loop tree to generate mutually dependent clock signals having predetermined temporal relationships between the respective edges.

10. Method (30) for synchronizing components using different clock signals, the method comprising the steps of:
reading (31) a data item (11; 12; 13; 14) into a first flip-flop (1), which is operated using a first clock signal (C1), at a first sampling point (SP1) correlating with a first edge of a first edge type of the first clock signal (C1);
reading (32) the data item (11; 12; 13; 14) from the first flip-flop (1) into a second flip-flop (2), which is operated using a second clock signal (C2), at a second sampling point (SP2) correlating with a second edge of the first edge type of the second clock signal (C2), which second edge directly follows the first edge, if the time interval (dT) between the occurrence of the first edge and the second edge is greater than a predeterminable threshold; and
reading (33) the data item (11; 12; 13; 14) from the first flip-flop (1) into the second flip-flop (2) at a third sampling point (SP3) correlating with a third edge of a second edge type of the second clock signal (C2), which third edge directly follows the second edge, if the time interval (dT) between the occurrence of the first edge and the second edge is smaller than or equal to a predeterminable threshold.

11. Method (30) according to claim 10, wherein the ratio between the rate of the first clock signal (C1) and the rate of the second clock signal (C2) corresponds to a fraction A / B, wherein A and B are natural numbers.

12. Method (30) according to one of the claims 10 and 11, wherein the first edge type is a positive edge and the second edge type is a negative edge.

13. Method (30) according to one of the claims 10 to 12, wherein the predeterminable threshold depends on the setup and hold times of the first and/or second flip-flop (1; 2).

14. Method (30) according to one of the claims 10 to 13, wherein the first and second flip-flop (1; 2) are D-flip-flops.

15. Method (30) according to one of the claims 10 to 14, wherein data items (D1) are read into the first flip-flop (1) at a sequence of the first sampling points (SP1) of the first clock signal (C1), and wherein the sequence (M) of the second and third sampling points (SP2; SP3) corresponding to the respective sequence of the first sampling points (SP1) is preconfigured in advance.

## Patentansprüche

1. Synchronisatorschaltung (200), die Folgendes umfasst:
ein erstes Flipflop (1), das mit einem ersten Taktsignal (C1) betrieben wird, wobei das erste Flipflop (1) konfiguriert ist, ein Datenelement (11; 12; 13; 14) an einem ersten Abtastpunkt (SP1), der mit einer ersten Flanke eines ersten Flankentyps des ersten Taktsignals (C1) korreliert, zu lesen;
ein zweites Flipflop (2), das unter Verwendung eines zweiten Taktsignals (C2) betrieben wird, wobei das zweite Flipflop (2) konfiguriert ist, das Datenelement (11; 12; 13; 14) aus dem ersten Flipflop (1) an einem Ausleseabtastpunkt zu lesen; und einen endlichen Zustandsautomaten (3), der mit dem zweiten Flipflop (2) gekoppelt ist,
wobei der endliche Zustandsautomat (3) konfiguriert ist, einen zweiten Abtastpunkt (SP2) als den Ausleseabtastpunkt des zweiten Flipflops (2) auszuwählen, wobei der zweite Abtastpunkt (SP2) mit einer zweiten Flanke des ersten Flankentyps eines zweiten Taktsignals (C2) korreliert, wobei die zweite Flanke direkt auf die erste Flanke folgt, falls das Zeitintervall (dT) zwischen dem Auftreten der ersten Flanke und der zweiten Flanke größer ist als ein vorbestimmbarer Schwellenwert, und
der endliche Zustandsautomat (3) konfiguriert ist, einen dritten Abtastpunkt (SP3) als den Ausleseabtastpunkt des zweiten Flipflops (2) auszuwählen, wobei der dritte Abtastpunkt (SP3) mit einer dritten Flanke eines zweiten Flankentyps des zweiten Taktsignals (C2) korreliert, wobei die dritte Flanke direkt auf die zweite Flanke folgt, falls das Zeitintervall (dT) zwischen dem Auftreten der ersten Flanke und der zweiten Flanke kleiner als oder gleich einem vorbestimmbaren Schwellenwert ist.

2. Synchronisatorschaltung (200) nach Anspruch 1, wobei ein Verhältnis zwischen der Rate des ersten Taktsignals (C1) und der Rate des zweiten Taktsignals (C2) einem Bruch A/B entspricht, wobei A und B natürliche Zahlen sind.

3. Synchronisatorschaltung (200) nach einem der Ansprüche 1 und 2, wobei der erste Flankentyp eine positive Flanke ist und der zweite Flankentyp eine negative Flanke ist.

4. Synchronisatorschaltung (200) nach einem der Ansprüche 1 bis 3, wobei der vorbestimmbare Schwellenwert von der Einstellung und Haltezeiten des ersten und/oder zweiten Flipflops (1; 2) abhängt.

5. Synchronisatorschaltung (200) nach einem der Ansprüche 1 bis 4, wobei das erste und das zweite Flipflop (1; 2) D-Flipflops sind.

6. Synchronisatorschaltung (200) nach einem der Ansprüche 1 bis 5, die ferner Folgendes umfasst:
ein drittes Flipflop (4), das unter Verwendung des zweiten Taktsignals (C2) betrieben wird und das mit dem zweiten Flipflop (2) gekoppelt ist, wobei das dritte Flipflop (4) konfiguriert ist, das Datenelement (21; 22; 23) aus dem zweiten Flipflop (2) an dem zweiten Taktsignal (C2) zu lesen.

7. Synchronisatorschaltung (200) nach einem der Ansprüche 1 bis 6, die ferner eine Anlaufschaltung (300) umfasst, wobei die Anlaufschaltung (300) Folgendes umfasst:
ein viertes Flipflop (7), das mit dem zweiten Taktsignal (C2) getaktet ist und mit dem endlichen Zustandsautomaten (3) gekoppelt ist;
ein fünftes Flipflop (8), das mit dem zweiten Taktsignal (C2) getaktet ist und mit dem vierten Flipflop (7) gekoppelt ist; und
ein sechstes Flipflop (9), das mit dem ersten Taktsignal (C1) getaktet ist,
wobei der endliche Zustandsautomat (3) konfiguriert ist, ein Startsignal (P1) in das vierte Flipflop (7) einzugeben und ein Bitmustersignal (P2) aus dem fünften Flipflop (8) zu empfangen, und wobei das sechste Flipflop (9) konfiguriert ist, ein Rücksetzungssignal (PE) zu dem fünften Flipflop (8) auszugeben, das das Bitmustersignal (P2) auf null zurücksetzt, falls eine Flanke des ersten Flankentyps des zweiten Taktsignals (C2) während der Verarbeitung des Startsignals (P1) in dem vierten und fünften Flipflop (7; 8) mit dem ersten Taktsignal (C1) auftritt.

8. Synchronisatorschaltung (200) nach Anspruch 7, die ferner Folgendes umfasst:
einen Zähler (10), der mit dem endlichen Zustandsautomaten (3) gekoppelt ist, wobei der Zähler (10) konfiguriert ist, die Reihenfolge (M) des zweiten und des dritten Abtastpunkts (SP2; SP3) abhängig von einer Bitfolge des Bitmustersignals (P2) zu steuern.

9. Synchronisatorschaltung (200) nach einem der Ansprüche 1 bis 8, wobei das erste Taktsignal (C1) und das zweite Taktsignal (C2) durch dieselbe Phasenregelschleife oder denselben Phasenregelschleifenbaum erzeugt werden, um wechselseitig abhängige Taktsignale, die vorbestimmte zeitliche Beziehungen zwischen den jeweiligen Flanken aufweisen, zu erzeugen.

10. Verfahren (30) zum Synchronisieren von Komponenten, die unterschiedliche Taktsignale verwenden, wobei das Verfahren die folgenden Schritte umfasst:
Lesen (31) eines Datenelements (11; 12; 13; 14) in ein erstes Flipflop (1), das unter Verwendung eines ersten Taktsignals (C1) betrieben wird, an einem ersten Abtastpunkt (SP1), der mit einer ersten Flanke eines ersten Flankentyps des ersten Taktsignals (C1) korreliert;
Lesen (32) des Datenelements (11; 12; 13; 14) aus dem ersten Flipflop (1) in ein zweites Flipflop (2), das unter Verwendung eines zweiten Taktsignals (C2) betrieben wird, an einem zweiten Abtastpunkt (SP2), der mit einer zweiten Flanke des ersten Flankentyps des zweiten Taktsignals (C2) korreliert, wobei die zweite Flanke direkt auf die erste Flanke folgt, falls das Zeitintervall (dT) zwischen dem Auftreten der ersten Flanke und der zweiten Flanke größer als ein vorbestimmbarer Schwellenwert ist; und
Lesen (33) des Datenelements (11; 12; 13; 14) aus dem ersten Flipflop (1) in das zweite Flipflop (2) an einem dritten Abtastpunkt (SP3), der mit einer dritten Flanke eines zweiten Flankentyps des zweiten Taktsignals (C2) korreliert, wobei die dritte Flanke direkt auf die zweite Flanke folgt, falls das Zeitintervall (dT) zwischen dem Auftreten der ersten Flanke und der zweiten Flanke kleiner als oder gleich einem vorbestimmbaren Schwellenwert ist.

11. Verfahren (30) nach Anspruch 10, wobei das Verhältnis zwischen der Rate des ersten Taktsignals (C1) und der Rate des zweiten Taktsignals (C2) einem Bruch A/B entspricht, wobei A und B natürliche Zahlen sind.

12. Verfahren (30) nach einem der Ansprüche 10 und 11, wobei der erste Flankentyp eine positive Flanke ist und der zweite Flankentyp eine negative Flanke ist.

13. Verfahren (30) nach einem der Ansprüche 10 bis 12, wobei der vorbestimmbare Schwellenwert von der Einstellung und Haltezeiten des ersten und/oder zweiten Flipflops (1; 2) abhängt.

14. Verfahren (30) nach einem der Ansprüche 10 bis 13, wobei das erste und zweite Flipflop (1; 2) D-Flipflops sind.

15. Verfahren (30) nach einem der Ansprüche 10 bis 14, wobei Datenelemente (D1) in das erste Flipflop (1) mit einer Reihenfolge der ersten Abtastpunkte (SP1) des ersten Taktsignals (C1) gelesen werden und wobei die Reihenfolge (M) der zweiten und der dritten Abtastpunkte (SP2; SP3), die der jeweiligen Reihenfolge der ersten Abtastpunkte (SP1) entspricht, im Voraus vorkonfiguriert werden.

## Revendications

1. Circuit de synchronisation (200), comprenant :
une première bascule (1) pilotée par un premier signal d'horloge (C1), la première bascule (1) étant configurée pour lire une donnée élémentaire (11 ; 12 ; 13 ; 14) à un premier point d'échantillonnage (SP1) se corrélant avec un premier flanc d'un premier type de flanc du premier signal d'horloge (C1) ;
une deuxième bascule (2) pilotée par un deuxième signal d'horloge (C2), la deuxième bascule (2) étant configurée pour lire la donnée élémentaire (11 ; 12 ; 13 ; 14) depuis la première bascule (1) à un point d'échantillonnage de lecture ; et
un automate d'états finis (3) couplé à la deuxième bascule (2),
l'automate d'états finis (3) étant configuré pour sélectionner un deuxième point d'échantillonnage (SP2) comme point d'échantillonnage de lecture de la deuxième bascule (2), le deuxième point d'échantillonnage (SP2) se corrélant avec un deuxième flanc du premier type de flanc d'un deuxième signal d'horloge (C2), le deuxième flanc suivant immédiatement le premier flanc, si l'intervalle de temps (dT) entre l'apparition du premier flanc et du deuxième flanc est supérieur à un seuil prédéterminable, et
l'automate d'états finis (3) étant configuré pour sélectionner un troisième point d'échantillonnage (SP3) comme point d'échantillonnage de lecture de la deuxième bascule (2), le troisième point d'échantillonnage (SP3) se corrélant avec un troisième flanc d'un deuxième type de flanc du deuxième signal d'horloge (C2), le troisième flanc suivant immédiatement le deuxième flanc, si l'intervalle de temps (dT) entre l'apparition du premier flanc et du deuxième flanc est inférieur ou égal à un seuil prédéterminable.

2. Circuit de synchronisation (200) selon la revendication 1, dans lequel un rapport entre la cadence du premier signal d'horloge (C1) et la cadence du deuxième signal d'horloge (C2) correspond à une fraction A/B, A et B étant des entiers naturels.

3. Circuit de synchronisation (200) selon l'une des revendications 1 et 2, dans lequel le premier type de flanc est un flanc positif et le deuxième type de flanc est un flanc négatif.

4. Circuit de synchronisation (200) selon l'une des revendications 1 à 3, dans lequel le seuil prédéterminable est fonction des temps d'établissement et de maintien de la première et/ou de la deuxième bascule (1 ; 2).

5. Circuit de synchronisation (200) selon l'une des revendications 1 à 4, dans lequel la première et la deuxième bascule (1 ; 2) sont des bascules D.

6. Circuit de synchronisation (200) selon l'une des revendications 1 à 5, comprenant en outre :
une troisième bascule (4) pilotée par le deuxième signal d'horloge (C2), couplée à la deuxième bascule (2), la troisième bascule (4) étant configurée pour lire la donnée élémentaire (21 ; 22 ; 23) depuis la deuxième bascule (2) au deuxième signal d'horloge (C2).

7. Circuit de synchronisation (200) selon l'une des revendications 1 à 6, comprenant en outre un circuit de démarrage (300), le circuit de démarrage (300) comprenant :
une quatrième bascule (7) cadencée par le deuxième signal d'horloge (C2), couplée à l'automate d'états finis (3) ;
une cinquième bascule (8) cadencée par le deuxième signal d'horloge (C2), couplée à la quatrième bascule (7) ; et
une sixième bascule (9) cadencée par le premier signal d'horloge (C1),
dans lequel l'automate d'états finis (3) est configuré pour appliquer un signal de démarrage (P1) à l'entrée de la quatrième bascule (7) et pour recevoir un signal de schéma (P2) en provenance de la cinquième bascule (8), et
dans lequel la sixième bascule (9) est configurée pour fournir un signal de réinitialisation (PE) à la cinquième bascule (8) réinitialisant à zéro le signal de schéma (P2), si un flanc du premier type de flanc du deuxième signal d'horloge (C2) apparaît au cours du traitement du signal de démarrage (pal) dans la quatrième et la cinquième bascule (7 ; 8) avec le premier signal d'horloge (C1).

8. Circuit de synchronisation (200) selon la revendication 7, comprenant en outre :
un compteur (10) couplé à l'automate d'états finis (3), le compteur (10) étant configuré pour commander la séquence (M) des deuxièmes et troisièmes points d'échantillonnage (SP2 ; SP3) en fonction d'une séquence de bits du signal de schéma (P2).

9. Circuit de synchronisation (200) selon l'une des revendications 1 à 8, dans lequel le premier signal d'horloge (C1) et le deuxième signal d'horloge (C2) sont générés par la même boucle à verrouillage de phase ou la même arborescence de boucles à verrouillage de phase afin de générer des signaux d'horloge interdépendants entretenant des relations temporelles prédéterminées entre les flancs respectifs.

10. Procédé (30) permettant de synchroniser des composants au moyen de signaux d'horloge différents, le procédé comprenant les étapes consistant à :
lire (31) une donnée élémentaire (11 ; 12 ; 13 ; 14) dans une première bascule (1), pilotée par un premier signal d'horloge (C1), à un premier point d'échantillonnage (SP1) se corrélant avec un premier flanc d'un premier type de flanc du premier signal d'horloge (C1) ;
lire (32) la donnée élémentaire (11 ; 12 ; 13 ; 14) depuis la première bascule (1) dans une deuxième bascule (2), pilotée par un deuxième signal d'horloge (C2), à un deuxième point d'échantillonnage (SP2) se corrélant avec un deuxième flanc du premier type de flanc du deuxième signal d'horloge (C2), le deuxième flanc suivant immédiatement le premier flanc, si l'intervalle de temps (dT) entre l'apparition du premier flanc et du deuxième flanc est supérieur à un seuil prédéterminable ; et
lire (33) la donnée élémentaire (11 ; 12 ; 13 ; 14) depuis la première bascule (1) dans la deuxième bascule (2) à un troisième point d'échantillonnage (SP3) se corrélant avec un troisième flanc d'un deuxième type de flanc du deuxième signal d'horloge (C2), le troisième flanc suivant immédiatement le deuxième flanc, si l'intervalle de temps (dT) entre l'apparition du premier flanc et du deuxième flanc est inférieur ou égal à un seuil prédéterminable.

11. Procédé (30) selon la revendication 10, dans lequel le rapport entre la cadence du premier signal d'horloge (C1) et la cadence du deuxième signal d'horloge (C2) correspond à une fraction AB, A et B étant des entiers naturels.

12. Procédé (30) selon l'une des revendications 10 et 11, dans lequel le premier type de flanc est un flanc positif et le deuxième type de flanc est un flanc négatif.

13. Procédé (30) selon l'une des revendications 10 à 12, dans lequel le seuil prédéterminable est fonction des temps d'établissement et de maintien de la première et/ou de la deuxième bascule (1 ; 2).

14. Procédé (30) selon l'une des revendications 10 à 13, dans lequel la première et la deuxième bascule (1 ; 2) sont des bascules D.

15. Procédé (30) selon l'une des revendications 10 à 14, dans lequel des données élémentaires (D1) sont lues dans la première bascule (1) à une séquence des premiers points d'échantillonnage (SP1) du premier signal d'horloge (C1), et dans lequel la séquence (M) des deuxièmes et troisièmes points d'échantillonnage (SP2 ; SP3) correspondant à la séquence respective des premiers points d'échantillonnage (SP1) est préconfigurée à l'avance.
